# EUROPEAN PATENT SPECIFICATION

(11) **EP 0 352 308 B1**
(45) Date of publication and mention of the grant of the patent: **28.07.1993**
(21) Application number: 89900684.5
(22) Date of filing: 24.03.1988
(51) Int. Cl.: C23C 14/34

(54) **METHOD OF SPUTTERING**
VERFAHREN FÜR DAMPFNIEDERSCHLAG
PROCEDE DE DEPOT PAR VAPORISATION

(30) Priority: 21.01.1988 US 146300
(43) Date of publication of application: 31.01.1990
(73) Proprietor: WEHNER, Gottfried, K., D-82131 Gauting (DE)
(72) Inventor: WEHNER, Gottfried, K., D-82131 Gauting (DE)
(74) Representative: Parr, Ronald Edward R.E. Parr & Co.
(86) International application number: US8800948
(87) International publication number: WO8906709

(56) References cited:
- US-A- 3 021 271
- US-A- 3 988 232
- Nature, Vol. 326, Issued 30 April 1987, R.E. Somekh et al, "High Superconducting transition temperatures in sputter-deposited YBaCuO thin films, pp 857-859
- Japanese Journal of Applied Physics, Volume 26, Number 5, Issued May 1987, H. Adachi et al "Preparation and Characterization of Superconducting Y-Ba-Cu-O Thin Films", pp L709-L710
- Japanese Journal of Applied Physics, Volume 26, Nunmber 5, Issued May 1987, M. Kawasaki et al, "High Tc Yb-Ba-Cu-O Thin Films Deposited on Sintered YSZ Substrates by Sputtering", pp L738-L740

## Description

The present invention pertains to sputtering by ion bombardment, deposition of multicomponent films, such as alloy or compound films consisting of two or more elements from the periodic table, and the substrate-target geometry in sputter deposition of a coating. More particularly, the present invention concerns a method for sputter deposition of films or coatings over large areas or at widely different substrate locations relative to the target where the coating is of exactly the same solid component composition as the target from where the material is being sputtered.

The main reason for deviations in a coating composition from that of a flat target is that the various species sputtered from the target have different angular distributions. If one species is for instance preferentially ejected in a direction normal to the target surface, then the law of CONSERVATION OF MASS in a closed system requires that this species must be deficient at another angle of ejection. Integrating the species over all ejection angles from zero (normal ejection) to +/-90 degrees must necessarily add up to the exact target composition. However, this conservation of matter does not apply for volatile gases such as oxygen when they are partly lost into the pump or gettered in other parts of the apparatus.

The angular distribution of the constituents in binary alloys was first studied by the inventor and published in a paper: R. R. Olson and G. K. Wehner, Journal of Vacuum Science and Technology, 14, page 316 (1976), followed by a more detailed later paper; R. R. Olson, M. E. King, and G. K. Wehner in Journal of Applied Physics, 50, page 3677 (1979). The sputtering of multicomponent materials is described in a survey article by Betz and Wehner in Topics of Applied Physics, Volume 52, Springer Verlag, N.Y. 1983.

The target geometry played a role in the early attempts in magnetron sputtering where cylindrical, conical and hemispherical targets (in the latter case for sputtering towards the inside of a hemisphere onto a flat substrate) were considered before magnetron sputtering from a planar target was invented, and patented by Chapin in U.S. Patent No. 4,166,018.

If a flat planar alloy target contains only two metals, one can always find an ejection angle in which the composition is the same as in the target. But this is not usually the case when more than two elements are involved because each species has its own angular distribution and there exists no ejection angle in which all three would come together to form a film with exactly the composition as that of the target. Furthermore, to be restricted in substrate location relative to the target is highly impractical. Another complication with a planar target is the fact that the angular distributions of different species change with the bombarding ion energy.

The present invention, which is set out in terms of independent method claim 1, and independent apparatus claim 15, overcomes the disadvantages of the prior art by not sputtering from a flat, but from at least one spherical or partially spherical target positioned in a uniform plasma of a triode or diode gas- or vapor-discharge or in a plasma which is created with radio frequency- or microwave-excitation. [Preferred embodiments are set out in the dependent claims]

The general purpose of the present invention is the use of a spherical target where the conservation of mass law, together with the spherical symmetry of the target, guarantees that the composition of solids in the deposit is the same as in the target, regardless of where the substrate (within limits) is located. Even if such additional effects, such as evaporation or resputtering from the substrate, or poor sticking of a component becomes involved, the conservation of matter in a spherical-closed system requires that the composition remains unchanged from that of the target, no matter with what ion energy it is sputtered. With a new target, it will require some short presputtering for establishing equilibrium conditions. The surface composition at the target then adjusts automatically to become different from that of the bulk in order to achieve the material removal with unchanged composition. It will, of course, be necessary to keep the target temperature below the value where constituents begin to move in the bulk and diffuse to the surface for replenishing the species which is most easily sputtered from there.

The present invention becomes less useful in a pressure regime where the mean free path of sputtered atoms becomes very short compared to the travel distance between target and substrate. The collisions between sputtered atoms and gas or vapor atoms then make the ejection direction from the target immaterial. But, many considerations exist for operating in the low gas pressure regime (0.132 Pa (10⁻³ Torr) with mean free paths of the sputtered atoms of several centimeters or larger) such as for retaining the high kinetic energy of sputtered atoms, or preventing the back diffusion of sputtered atoms to the target which lowers the deposition rate, or providing better adherence of those coatings.

Sputtering from a sphere at low gas pressure instead of from a flat target creates another very significant difference, namely with respect to the energies of the impinging atoms because they come not only from normal but as well from obliquely ejected atoms which are known to have higher ejection energies. This improves not only film adherence, compound formation, nucleation, and surface movements of atoms which in turn are beneficial for epitaxy at low substrate temperature.

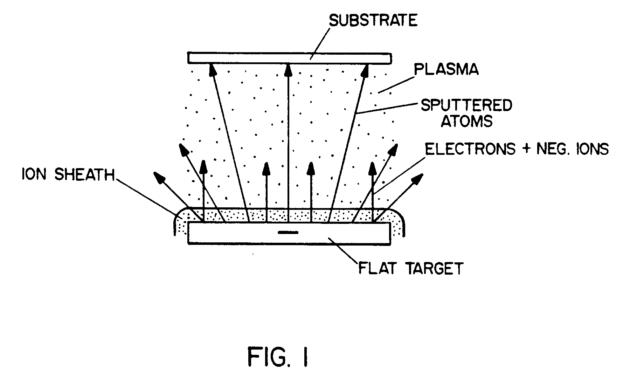

In oxygen-containing targets or in plasmas or targets which contain other electronegative species, one has to deal with another problem which is related to the fact that many of these atoms are sputtered in the form of negative ions. These are accelerated in the positive ion sheath to the full sputtering voltage in a direction normal to the target surface forming, in the case of a flat target as shown in FIG.1, a negative ion beam which can resputter the material from a substrate located opposite the flat target. With a spherical target, these ions do not form a beam, but leave the target in radial directions. If all such atoms would leave as negative ions and become imbedded in the deposit, the conservation of matter would even hold for such volatile species as oxygen, etc.

Magnetron sputtering from prior art flat targets, such as in FIG. 1, was invented not only for increasing the deposition rate, but for preventing the target-released electrons from bombarding and heating the substrate. At the spherical target or targets, these electrons are distributed over the whole surrounding volume which eliminates the need for magnetic fields for deflecting these electrons.

The spherical target will even solve problems which arise when a single element target is sputtered in an electronegative gas plasma for producing two component coatings such as metal oxides. The bombarding positive oxygen ions are on impact partly converted into negative ions which again form in the case of a flat target a beam normal to the target surface, which is undesirable because they cause resputtering of material from the substrate. With a spherical target, those ions are however accelerated in radial directions and are therefore much diluted.

The present invention is particularly useful for the recently discovered ceramic high Tc superconductor materials.

The teachings of the present invention are also applicable in the following areas:
1. Superconducting compounds such as NbSn, NbTi, NbGe etc., i.e., other than the new ceramic high Tc materials.
2. Semiconductor films such as GaAs, AlGaAs, HgCdTe, etc.
3. Intermetallic compounds for improved corrosion, and wear resistance and greater hardness such as PtCr at the cutting edges of razor blades.
4. MoS₂ films for improved lubrication.
5. Cermet films for fabricating coatings with specific sheet resistance.
6. Hard coatings such as SiC, or WC or other metal carbides, borides or silicides.
7. Coatings with desired optical (solar, TiN gold colored) or magnetic properties such as MnBi or CoCr for perpendicular magnetic recording.

And many others in which optimized mechanical (wear, hardness, friction, etc.), or optical, or electrical, or magnetic or magnetio-optical properties are desired.

Other objects of the present invention and many of the attendant advantages of the present invention will be readily appreciated as the same becomes better understood by reference to the following detailed description when considered in connection with the accompanying drawings:
**FIG. 1** illustrates prior art of sputtering from a flat target;
**FIG. 2** illustrates the present invention of sputtering from a large spherical target to a substrate;
**FIG. 3** illustrates the present invention of sputtering from a small spherical target to a substrate; and,
**FIG. 4** illustrates a resistivity versus absolute temperature graph of a sputter-deposited superconductor film from a 123 target.

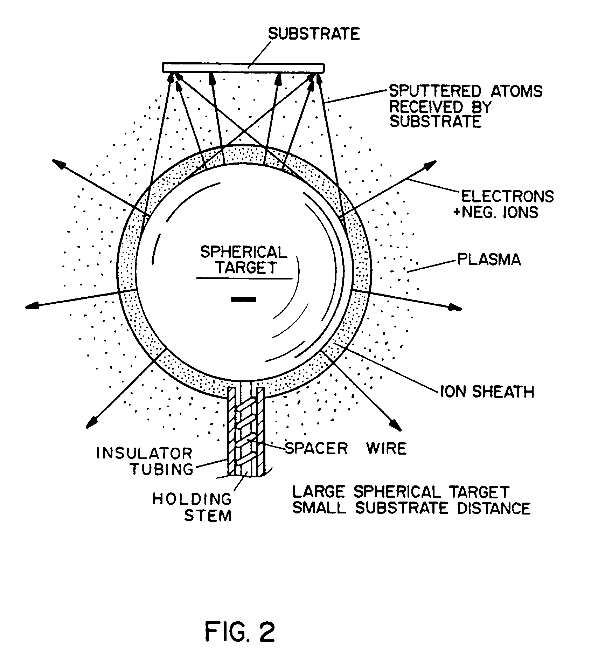

**FIG. 2** illustrates an electrically conducting target sphere held in position and connected to the negative pole of the DC-, or in the case of insulator coatings on a metal sphere, to an RF-sputter power supply. The allowed substrate positions are limited to those not in line of sight with the sphere area where the connection is made. The connecting lead to the sphere needs, of course, to be insulated from the plasma so that it would not be subject to sputtering. The sphere can be made of the material to be sputtered or can be a metal sphere which is coated with a sufficiently thick layer of the material to be sputtered.

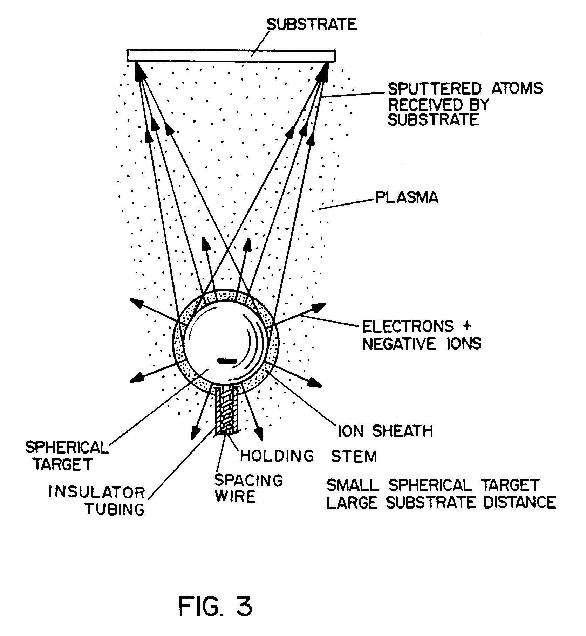

The distance between sphere and substrate and the sphere size have no influence on the composition, but both affect the deposition rate. The relationship of the target sphere to the substrate must be such that sputtered atoms reach the substrate over the ejection angle range from -90° through 0 to +90°. The only portion of a sphere that is required is that which provides such an ejection angle range over all parts of the substrate. If one tries to achieve high uniformity of the deposition rate over a flat surface, one should use a small target sphere and a large substrate distance like shown in FIG. 3, but then the deposition rate will become very small. If one uses the case of FIG. 2 with the substrate closer to a large target sphere, it may not only become difficult to fill the space between substrate and target with a dense uniform plasma, but the deposition rate on a flat target becomes more non-uniform unless one uses mechanical motions.

In practical applications, one will most likely seek a compromise in sphere size and distances depending on what is more of a premium, namely the deposition rate or thickness uniformity. A larger sphere is easier to cool which becomes necessary when one aims toward a high sputtering rate of a single sphere. High rates can readily be obtained with a high plasma density such as produced in a Hg triode discharge, and also with a triode noble gas discharge. One can in this case connect tubings to a hole in the target sphere or to a hollow metal sphere which is coated with sufficiently thick deposits of the material to be desired. For simpler cooling without hollowing the sphere one might narrow the allowed substrate locations by using not a full, but less than half a target sphere for the case of FIG. 2, or somewhat more than half a sphere for the case of FIG. 3, and connect these partial spheres to a cooling platform which needs, of course, to be protected from sputtering. The substrate should not be in the line of sight of the location where the support for holding or cooling the spherical target is made.

Sputtering of insulators can only be accomplished with RF power applied to a metal sphere which has the insulating material to be sputtered affixed to the outer surface of the sphere.

The fact that the compositions of the deposits sputtered from spherical targets are maintained independent of substrate positions (within the limits as discussed), and independent of the distance between target and substrate, makes it possible to use more than one plasma-immersed spherical target, in particular in the case that the substrate-target distances are much larger than the target spheres. For tripling, in this case, the deposition rate, and achieving on a flat substrate better deposition rate uniformity, three such spherical targets are arranged in a triangular configuration pointing towards a substrate located in a direction normal to the center of the triangle. Spherical targets can also be arranged in a row for creating a "line source" of sputtered material, such as is usually used with "race track" magnetron sputtering sources for coating large glass panels which are transported continuously across the line source sputtering target. Furthermore, the targets can be arranged in a circle, and a wire or rod to be sputter coated is drawn continuously through the center of the circle. Furthermore, many spherical targets can be positioned in a triangular matrix fashion, or even in a three dimensional configuration, for achieving high deposition rate and high uniformity in thickness over large flat areas. One has only to make sure that each individual sphere is surrounded by a uniform plasma density. As explained above, the places where the sphere holders connect to the spheres should be out of line of sight of the substrates.

The immediate impact of the present invention is in the film deposition of the Y₁Ba₂Cu₃O₇₋ₓ (referred to as 123) ceramic superconductors. These materials are pressed from powders which are mixed in the proper proportions and sintered, and annealed in oxygen at high temperature. Thin films of these materials are usually synthesized by vacuum evaporation or sputtering from two or three sources containing Y, Ba and Cu metals or their compounds. To achieve exactly the 123 composition of the metals in the deposits is not a simple task because it requires flux monitoring for each separate source and the location where one obtains exactly the 123 composition is very limited. Sputtering from a single superconducting 123 target would be much simpler, but has so far not been very successful, at least not for producing 123 films over larger areas in the prior art. In some cases, the desired 123 composition in the deposit can be improved by changing the target composition accordingly.

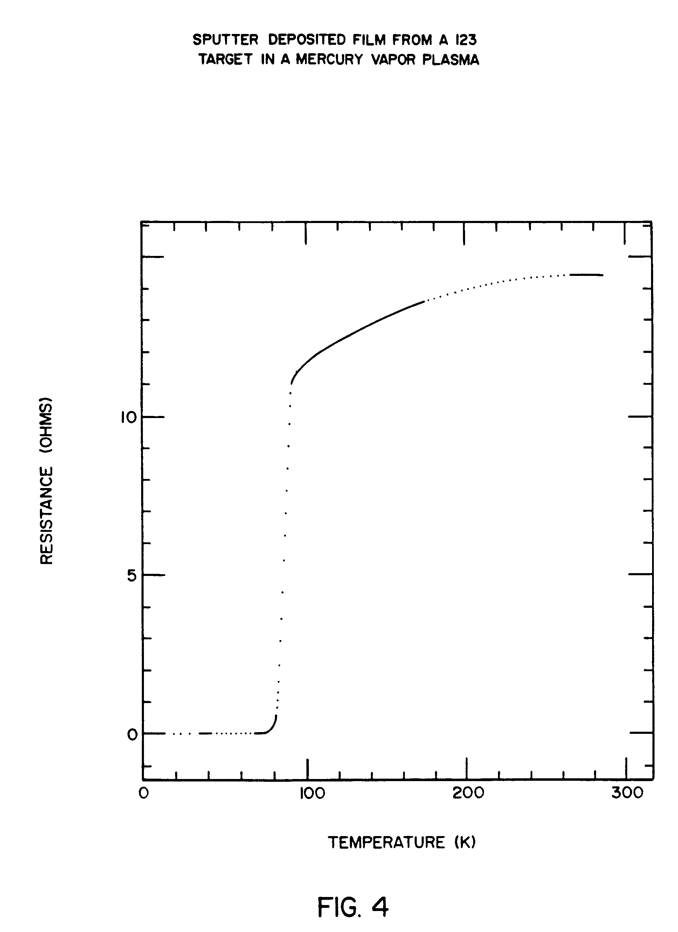

Example: A crude hemisphere of about 4mm radius was shaped on a grinding wheel out of a 123 disc. A 700 nm thick film was sputtered from this hemisphere onto a SrTiO₃ crystal substrate which was symmetrically opposite the hemispherical target. With a full sphere, the substrate position would have become less restricted. The graph of FIG. 4 illustrates the results.

The present invention was experimentally proven in a mercury triode plasma with the electrons supplied from a cathode spot ignited on a Hg pool. The reason for this plasma was the fact that this equipment was in place and operational, and that the inventor has a long experience in this equipment. The same results will no doubt be obtained in a noble gas triode discharge.

The apparatus is described in U.S. Patent No. 3,021,271 by Wehner, the applicant. The only change concerns the elimination of grid #16 and the repeller #32 because both would be subject to sputtering, and therefore, add undesired impurity metals. The deposit of Fig. 4 was obtained by replacing the flat target #36 with the hemispherical target of the 123 superconductor pointing with its symmetry axis towards the substrate #34.

The specifics of one example (with the results shown in FIG. 4) of the present invention are as follows: The target hemisphere had 4mm radius. The substrate was a 5x6x1mm SrTiO₃ crystal mounted about 4cm away from the target. The main discharge current between cathode #22 and anode #30 was 4 amp with a voltage drop between anode and cathode of 25 volt. The lower part of the Pyrex tube was immersed in water which was chilled to 11°C which sets the vapor pressure of Hg at about 0.066 Pa (5x10⁻⁴ Torr). The tube was pumped with a 12L/sec Hg diffusion pump. The target voltage was 300 volt negative w.r.t. anode (which is very close to plasma potential), and drew 2mA ion current from the plasma. The floating voltage in this low pressure, very non-thermal, plasma was minus 17 volt w.r.t. anode which of course helps to sputter-clean the insulating substrate before sputter deposition is started. The thickness of the deposited film was 700 nm and this was obtained in about 11 hours of sputtering.

Fig. 4 shows that the whole resistance curve from 300°K to 92°K curves downward, which differs from most other published data. The T (10% to 90%) is still rather high. Full superconductivity is reached at 76°K. The sample is an insulator after deposition, and requires the usual oxygen annealing procedure for incorporating the right amount of oxygen. The procedure was: 650°C for 90 min, 750°C for 30 min, 850°C for 20 min and 920°C for 3.5 min with subsequent slow cooling in oxygen to room temperature.

These films always need such a high temperature heat treatment after deposition for accomplishing the O₇₋ₓ (x 1) composition and for converting the material to the orthorhombic structure.

Various modifications can be made to the present invention without departing from the apparent scope hereof. Whatever new materials with still higher superconductor transition temperatures may be discovered, no matter how complicated in their composition, they can with the present invention readily be transferred from a target to a film on a substrate with unchanged composition over larger areas. Further, the teachings of the present invention apply to spheres which are substantially spherical, such as a partial sphere or a hemisphere.

## Claims

1. A method of sputter-depositing a film or coating from a target on to one or more substrates, comprising the steps of:
a. using a target at least part of whose surface is spherical and comprises a plurality of constituents in desired proportions, and immersing the target in a low pressure plasma of uniform plasma density;
b. providing the target with a metal wire or rod for applying the negative sputtering voltage, carrying the current and for holding the target in the plasma; and
c. positioning the substrate or substrates without any obstruction of a line-of-sight between the spherical part of the target and the substrate(s) such that the material deposited thereupon consists of atoms which have been ejected from the spherical surface over the ejection angle range from - 90° through 0° to + 90°, whereby, over all parts of the substrate(s), the proportions of the constituents in the deposited film are the same as those in the target.

2. The method of claim 1 comprising the step of immersing said spherical target in a uniform low pressure plasma of a triode discharge.

3. The method of claim 1 comprising the step of making the spherical target the cathode in a low pressure diode discharge.

4. The method of claim 1 comprising the step of immersing the spherical target in a low pressure RF excited plasma.

5. The method of claim 1 comprising the step of immersing the spherical target in a microwave excited plasma.

6. The method of claim 1 comprising the step of using a target of a spherical metal sphere which is coated with the material to be sputtered.

7. The method of claim 1 or claim 4 wherein said target is coated with an insulator and sputtered by applying RF to the metal sphere.

8. The method of claim 1 comprising the step of cooling the target.

9. The method of claim 1 or using more than one spherical target, each of said targets immersed in said low pressure plasma for increasing deposition rate and for obtaining on the flat surface of said substrate a greater deposition thickness uniformity.

10. The method of claim 1 comprising the steps of:
a. arranging target spheres in a circular fashion for sputtering onto wires or rod substrates; and,
b. moving said wire or rod substrates through the center of the circle for coating the substrates uniformly.

11. The method of claim 1 comprising the steps of sputtering in a low pressure mercury triode plasma where the electrons for plasma formation are supplied from cathode spots ignited and sustained on a liquid mercury pool.

12. The method of claim 1 wherein said spherical targets are of at least one high TC superconducting material for sputter-depositing films or coatings.

13. The method of claim 12 wherein said superconductor material is a 123 ceramic superconductor.

14. A method according to Claim 1, wherein said plurality of constituents comprises an inter-metallic compound.

15. Apparatus for use in a method of sputter deposition on one or more substrates, comprising
(a) one or more targets at least part of whose surface is spherical and comprises a plurality of constituents in desired proportions which have different angular distributions of emitted particles;
(b) means for providing a low pressure plasma of uniform plasma density;
(c) a metal rod or wire for applying the negative sputtering voltage, carrying the current and for holding the target in the plasma; and
(d) means for positioning substrates without any obstruction of a line-of-sight between the spherical part of the target and the substrates such that deposited material consists of atoms which were ejected from the target spherical surface over the ejection angle range from -90° through 0° to + 90°, whereby the target constituents are deposited over all parts of the substrate in the same proportions as said target constituents exist in the target.

16. Apparatus according to Claim 15, wherein the plasma is a low pressure mercury triode plasma where the electrons for plasma formation are supplied from cathode spots ignited and sustained on a liquid pool of mercury.

17. Apparatus according to Claim 15 or 16 wherein said plurality of constituents comprises a superconductor material.

18. Apparatus according to Claim 17 wherein said superconductor material is 123 ceramic superconductor material

## Patentansprüche

1. Verfahren des Zerstäubungsbeschichtens eines Films oder einer Schicht von einer Elektrode auf ein Substrat oder mehrere Substrate mit den Schritten:
a. Verwenden einer Elektrode, deren Oberfläche wenigstens teilweise kugelförmig ist und eine Vielzahl von Bestandteilen in gewünschten Abmessungen aufweist, und Eintauchen der Elektrode in ein Plasma geringen Druckes einheitlicher Dichte;
b. Versehen der Elektrode mit einem Metalldraht oder einem Metallstab zum Anlegen der negativen Zerstäubungsspannung, Führen des Stroms und Halten der Elektrode in dem Plasma; und
c. Anordnen des Substrats oder der Substrate ohne irgendeine Behinderung der Sichtlinie zwischen dem kugelförmigen Teil der Elektrode und dem(n) Substrat(en), so daß das darauf abgelagerte Material aus Atomen besteht, welche von der kugelförmigen Oberfläche über den Ausstoßwinkelbereich von -90° über 0° bis +90° ausgestoßen worden sind, wodurch, über alle Teile des (der) Substrats (Substrate), die Anteile der Bestandteile in dem abgelagerten Film die gleichen sind wie diejenigen in der Elektrode.

2. Verfahren nach Anspruch 1, mit dem Schritt Eintauchen der kugelförmigen Elektrode in ein einheitliches Plasma geringen Druckes einer Triodenentladung.

3. Verfahren nach Anspruch 1, mit dem Schritt Machen der kugelförmigen Elektrode zu einer Kathode in einer Niederdruckdiodenentladung.

4. Verfahren nach Anspruch 1 mit dem Schritt Eintauchen der kugelförmigen Elektrode in ein durch Hochfrequenz angeregtes Plasma.

5. Verfahren nach Anspruch 1 mit dem Schritt Eintauchen der kugelförmigen Elektrode in ein durch Mikrowellen angeregtes Plasma.

6. Verfahren nach Anspruch 1 mit dem Schritt Verwenden einer Elektrode einer kugelförmigen Metallkugel, welche mit dem Material beschichtet ist, das zerstäubt werden soll.

7. Verfahren nach Anspruch 1 oder 4, bei welchem die Elektrode mit einem Isolator beschichtet und durch Anlegen von Hochfrequenz an die Metallkugel zerstäubt wird.

8. Verfahren nach Anspruch 1 mit dem Schritt Kühlen der Elektrode.

9. Verfahren nach Anspruch 1 bei Verwendung mehrerer kugelförmiger Elektroden, wobei jede der Elektroden in das Plasma geringen Druckes eingetaucht ist zum Erhöhen der Beschichtungsrate und zum Erhalten einer größeren Gleichmäßigkeit der Beschichtungsdicke der ebenen Oberfläche des Substrats.

10. Verfahren nach Anspruch 1 mit den Schritten:
a. Anordnen von Elektrodenkugeln in einem Kreis zum Zerstäuben auf Draht- oder Stabsubstrate; und
b. Bewegen der Draht- oder Stabsubstrate durch die Mitte des Kreises zum gleichmäßigen Beschichten der Substrate.

11. Verfahren nach Anspruch 1 mit den Schritten Zerstäuben in einem Quecksilberplasma geringen Drucks, wobei die Elektronen zur Plasmabildung von Kathodenansatzpunkten geliefert werden, welche auf einem Flüssigquecksilberbad angeregt und unterhalten werden.

12. Verfahren nach Anspruch 1, bei welchem die kugelförmigen Elektroden aus wenigstens einem supraleitenden Material mit hohem Tc-Gehalt zum Zerstäubungsbeschichten von Filmen oder Schichten bestehen.

13. Verfahren nach Anspruch 12, bei welchem das supraleitende Material ein 123-keramischer Supraleiter ist.

14. Verfahren nach Anspruch 1, bei welchem die Vielzahl von Bestandteilen eine intermetallische Verbindung enthält.

15. Vorrichtung zur Anwendung in einem Verfahren des Zertäubungsbeschichtens auf ein Substrat oder mehrere Substrate, mit:
(a) einer oder mehreren Elektrode(n), deren Oberfläche wenigstens teilweise kugelförmig ist und eine Vielzahl von Bestandteilen in gewünschten Abmessungen aufweist, welche unterschiedliche Winkelverteilungen von austretenden Partikeln haben;
(b) Mitteln zum Bereitstellen eines Plasmas geringen Druckes gleichmäßiger Dichteverteilung;
(c) einem Metallstab oder -draht zum Anlegen der Zerstäubungsspannung, Leiten des Stromes und Halten der Elektrode in dem Plasma; und
(d) Mitteln zum Anordnen von Substraten ohne irgendeine Behinderung der Sichtlinie zwischen der Elektrode und den Substraten derart, daß das abgelagerte Material aus Atomen besteht, welche von der kugleförmigen Elektrodenoberfläche über den Ausstoßwinkelbereich von -90° über 0° bis +90° ausgestoßen wurden, wodurch die Elektrodenbestandteile über alle Teile des Substrats in denselben Anteilen abgelagert werden, wie die Elektrodenbestandteile in der Elektrode vorkommen.

16. Vorrichtung nach Anspruch 15, bei welcher das Plasma ein Niederdruck-Quecksilbertriodenplasma ist, in welchem die Elektronen zur Plasmabildung von Kathodenansatzpunkten geliefert werden, welche auf einem Flüssigquecksilberbad angeregt und unterhalten werden.

17. Vorrichtung nach Anspruch 15 oder 16, bei welcher die Vielzahl von Bestandteilen ein supraleitendes Material enthält.

18. Vorrichtung nach Anspruch 17, bei welcher das supraleitende Material 123-keramisches Supraleitermaterial ist.

## Revendications

1. Procédé de dépôt par pulvérisation cathodique d'un film ou d'un revêtement à partir d'une cible sur un ou plusieurs substrats, comprenant les étapes consistant a :
(a) utiliser une cible, dont au moins une partie de la surface est sphérique et comprend une pluralité de constituants dans des proportions désirées, et plonger la cible dans un plasma basse pression de densité de plasma uniforme ;
(b) doter la cible d'un fil métallique ou d'une tige métallique pour appliquer la tension négative de pulvérisation cathodique, transportant le courant, et pour maintenir la cible dans le plasma ; et
(c) positionner le substrat ou les substrats sans obstruction d'une ligne de visée entre la partie sphérique de la cible et le (ou les) substrat(s), de telle sorte que la matière déposée sur celui-ci (ou ceux-ci) consiste en atomes qui ont été éjectés de la surface sphérique sur la plage d'angles d'éjection de -90° à +90° en passant par 0°, ce par quoi, sur toutes les parties du (ou des) substrat(s), les proportions des constituants dans le film déposé sont les mêmes que celles dans la cible.

2. Procédé selon la revendication 1, comprenant l'étape consistant à plonger ladite cible sphérique dans un plasma basse pression uniforme d'une décharge de triode.

3. Procédé selon la revendication 1, comprenant l'étape consistant à faire de la cible sphérique la cathode dans une décharge de diode basse pression.

4. Procédé selon la revendication 1, comprenant l'étape consistant à plonger la cible sphérique dans un plasma à excitation par radiofréquence basse pression.

5. Procédé selon la revendication 1, comprenant l'étape consistant à plonger la cible sphérique dans un plasma à excitation par microonde.

6. Procédé selon la revendication 1, comprenant l'étape consistant à utiliser une cible constituée par une sphère métallique sphérique qui est revêtue par la matière devant être appliquée par pulvérisation cathodique.

7. Procédé selon la revendication 1 ou la revendication 4, dans lequel ladite cible est revêtue par un isolant et pulvérisée par application d'une radiofréquence à la sphère métallique.

8. Procédé selon la revendication 1, comprenant l'étape de refroidissement de la cible.

9. Procédé selon la revendication 1, utilisant plus d'une cible sphérique, chacune desdites cibles étant plongée dans ledit plasma basse pression pour augmenter la vitesse de dépôt et pour obtenir, sur la surface plane dudit substrat, une plus grande uniformité d'épaisseur de dépôt.

10. Procédé selon la revendication 1, comprenant les étapes consistant à :
(a) disposer des sphères cibles de façon circulaire pour la pulvérisation cathodique sur des substrats de type fils métalliques ou tiges métalliques ; et
(b) déplacer lesdits substrats de type fils métalliques ou tiges métalliques à travers le centre du cercle pour revêtir les substrats de façon uniforme.

11. Procédé selon la revendication 1, comprenant les étapes consistant à conduire la pulvérisation cathodique dans un plasma de triode à mercure basse pression, où les électrons pour la formation du plasma sont fournis à partir de spots cathodiques prenant naissance et entretenus sur un bain de mercure liquide.

12. Procédé selon la revendication 1, dans lequel lesdites cibles sphériques sont en au moins un matériau supraconducteur à TC élevé pour le dépôt par pulvérisation cathodique de films ou de revêtements.

13. Procédé selon la revendication 12, dans lequel ledit matériau supraconducteur est un supraconducteur de céramique 123.

14. Procédé selon la revendication 1, dans lequel ladite pluralité de constituants comprend un composé intermétallique.

15. Appareil destiné à être utilisé dans un procédé de dépôt par pulvérisation cathodique sur un ou plusieurs substrats, comprenant :
(a) une ou plusieurs cibles, dont au moins une partie de la surface est sphérique et comprend une pluralité de constituants dans des proportions désirées qui ont différentes distributions angulaires de particules émises ;
(b) des moyens pour fournir un plasma basse pression de densité de plasma uniforme ;
(c) une tige métallique ou un fil métallique pour appliquer la tension négative de pulvérisation cathodique, transportant le courant, et pour maintenir la cible dans le plasma ; et
(d) des moyens pour positionner des substrats sans obstruction d'une ligne de visée entre la partie sphérique de la cible et les substrats, de telle sorte que la matière déposée consiste en atomes qui ont été éjectés de la surface sphérique de la cible sur la plage d'angles d'éjection de -90° jusqu'à +90° en passant par 0°, ce par quoi les constituants de la cible sont déposés sur toutes les parties du substrat dans les mêmes proportions que celles desdits constituants de la cible dans la cible.

16. Appareil selon la revendication 15, dans lequel le plasma est un plasma de triode au mercure basse pression, où les électrons pour la formation du plasma sont fournis par des spots cathodiques prenant naissance et entretenus sur un bain liquide de mercure.

17. Appareil selon la revendication 15 ou 16, dans lequel ladite pluralité de constituants comprend un matériau supraconducteur.

18. Appareil selon la revendication 17, dans lequel ledit matériau supraconducteur est un matériau supraconducteur de céramique 123.
